# EUROPÄISCHE PATENTANMELDUNG

(11) **EP 2 584 304 A1**
(43) Veröffentlichungstag der Anmeldung: **24.04.2013**
(21) Anmeldenummer: 12007214.5
(22) Anmeldetag: 18.10.2012
(51) Int. Cl.: G01B 7/14, G01D 5/14, G01R 33/07, H01L 43/06

(54) **Verfahren zur Bestimmung eines Abstandes und eine integrierte Magnetfeldmessvorrichtung**

(30) Priorität: 21.10.2011 DE 102011116545
(71) Anmelder: Micronas GmbH, 79108 Freiburg (DE)
(72) Erfinder: Heberle, Klaus, 79312 Emmendingen (DE)
(74) Vertreter: Koch Müller Patentanwaltsgesellschaft mbH

(57) **Zusammenfassung**

Integrierte Magnetfeldmessvorrichtung, mit einem auf einem Metallträger angeordneten Halbleiterkörper, aufweisend eine erste Oberfläche und mehreren auf der Oberfläche ausgebildeten Metallflächen, einem in dem Halbleiterkörper ausgebildeten ersten Magnetfeldsensor mit einem ersten Sensorsignal und zweiten Magnetfeldsensor mit einem zweiten Sensorsignal, einem stromdurchflossenen ersten Leiter, wobei ein dritter Magnetfeldsensor mit einem dritten Sensorsignal in dem Halbleiterkörper ausgebildet ist und der erste Magnetfeldsensor, der zweite Magnetfeldsensor und der dritte Magnetfeldsensor eine im Wesentlichen gleiche Ausrichtung zu dem Erdmagnetfeld und einen unterschiedlichen Abstand zu dem ersten Leiter aufweisen und das Magnetfeld des ersten Leiters gleichzeitig den ersten Magnetfeldsensor, den zweiten Magnetfeldsensor und den dritten Magnetfeldsensor durchdringt.

## Beschreibung

Die Erfindung betrifft ein Verfahren zur Bestimmung eines Abstandes und eine integrierte Magnetfeldmessvorrichtung gemäß dem Oberbegriff des Patentanspruchs 1 und des Oberbegriff des Patentanspruchs 4.

Aus der DE 199 46 935 A1, der US 6 917 193 B1, der US 2007 022 906 0 A1, der DE 197 41 417 B4 und der DE 10 2007 041 230 B3 sind unterschiedliche Ansätze zur Ausbildung einer Magnetfeldmessvorrichtung bekannt. Des Weiteren sind aus der US 2011 / 0046906 A1, der US 2011 / 0057 650 A1, der US 2005 / 0286 190 A1 und der US 2007 / 0 229 060 A1 weitere Verfahren und Vorrichtungen bekannt.

Vor diesem Hintergrund besteht die Aufgabe der Erfindung darin, eine Vorrichtung anzugeben, die den Stand der Technik weiterbildet.

Die Aufgabe wird durch ein Verfahren und durch eine integrierte Magnetfeldmessvorrichtung mit den Merkmalen des Patentanspruchs 1 und des Patentanspruchs 4 gelöst. Vorteilhafte Ausgestaltungen der Erfindung sind Gegenstand von Unteransprüchen.

Gemäß dem ersten Gegenstand der Erfindung wird ein Verfahren zur Bestimmung eines Abstandes eines stromdurchflossenen ersten Leiters mittels einer integrierten Magnetfeldmessvorrichtung bereitgestellt, wobei die integrierte Magnetfeldmessvorrichtung einen Halbleiterkörper mit einem in dem Halbleiterkörper ausgebildeten ersten Magnetfeldsensor und zweiten Magnetfeldsensor und dritten Magnetfeldsensor aufweist, wobei von dem ersten Magnetfeldsensor ein erstes Sensorsignal bereitgestellt wird und von dem zweiten Magnetfeldsensor ein zweites Sensorsignal bereitgestellt wird und von dem dritten Magnetfeldsensor ein drittes Sensorsignal bereitgestellt wird, und der erste Magnetfeldsensor und der zweite Magnetfeldsensor und der dritte Magnetfeldsensor von dem Magnetfeld des ersten Leiters gleichzeitig durchdrungen werden und zur Ermittlung des Abstandes der Magnetfeldmessvorrichtung von dem stromdurchflossenen Leiter eine erste Differenz aus dem ersten Sensorsignal und dem zweiten Sensorsignal und eine zweite Differenz aus dem dritten und dem zweiten Sensorsignal bestimmt wird und anschließend ein Quotient aus der ersten Differenz und der zweiten Differenz gebildet wird.

Gemäß dem zweiten Gegenstand der Erfindung wird eine integrierte Magnetfeldmessvorrichtung zur Bestimmung eines ersten Abstandes der Magnetfeldmessvorrichtung zu einem stromdurchflossenen ersten Leiter bereitgestellt, mit einem auf einem Metallträger angeordneten Halbleiterkörper und einem in dem Halbleiterkörper ausgebildeten ersten Magnetfeldsensor mit einem ersten Sensorsignal und einem in dem Halbleiterkörper ausgebildeten zweiten Magnetfeldsensor mit einem zweiten Sensorsignal und einem in dem Halbleiterkörper ausgebildeten dritten Magnetfeldsensor mit einem dritten Sensorsignal, wobei der erste Magnetfeldsensor und der zweite Magnetfeldsensor und der dritte Magnetfeldsensor einen unterschiedlichen Abstand zu dem ersten Leiter aufweisen und das Magnetfeld des ersten Leiters gleichzeitig den ersten Magnetfeldsensor, den zweiten Magnetfeldsensor und den dritten Magnetfeldsensor durchdringt, wobei eine Steuereinrichtung ausgebildet und eingerichtet ist, eine erste Differenz aus dem ersten Sensorsignal und dem zweiten Sensorsignal und eine zweite Differenz aus dem dritten Sensorsignal und dem zweiten Sensorsignal zu bestimmen und einen Quotienten aus der ersten Differenz und der zweiten Differenz zu bilden und aus dem Quotienten den ersten Abstand zwischen der Magnetfeldmessvorrichtung und dem ersten Leiter zu ermitteln.

Ein Vorteil der integrierten Magnetfeldmessvorrichtung ist es, das sich mittels von wenigstens drei Magnetfeldsensoren der Abstand eines stromdurchflossenen Leiters zu den Magnetfeldsensoren aus der unterschiedlichen Höhe der Sensorsignale der einzelnen Magnetfeldsensoren und der Kenntnis des Abstands zwischen den drei Magnetfeldsensoren bestimmen lässt. Hierfür wird eine Differenzbildung zwischen den Sensorsignalen durchgeführt. Weiterhin ist es vorteilhaft, dass sich die Magnetfeldmessvorrichtung ohne den stromdurchflossenen bzw. magnetfeldbehafteten Leiter monolithisch kostengünstig integrieren lässt. Vorzugsweise wird die Magnetfeldmessvorrichtung mittels eines CMOS Prozesses hergestellt. Untersuchungen haben gezeigt, dass sich die Abstände der einzelnen Magnetfeldsensoren zueinander während des CMOS Herstellungsprozesses sehr genau vorgeben lassen. Auch lassen sich die Magnetfeldsensoren jeweils sehr genau ausrichten und mit im Wesentlichen gleichartigen Eigenschaften produzieren. In einer ersten Ausführungsform ist es bevorzugt, dass der zweite Magnetfeldsensor von dem ersten Magnetfeldsensor und dem dritten Magnetfeldsensor unterschiedlich beabstandet ist. In einer alternativen Ausführungsform ist der Abstand zwischen dem ersten Magnetfeldsensor und dem zweiten Magnetfeldsensor gleich groß wie der Abstand zwischen dem zweiten Magnetfeldsensor und dem dritten Magnetfeldsensor.

Ein weiterer Vorteil Ist, dass sich die integrierte Magnetfeldmessvorrichtung zur Ausblendung eines überlagerten Magnetfeldes, wobei die Änderung des magnetischen Flusses zwischen dem ersten Magnetfeldsensor und dem zweiten Magnetfeldsensor und dem dritten Magnetfeldsensor genau Null oder nahezu Null ist, verwenden lässt. Derartige Felder lassen sich als magnetische Gleichfelder bezeichnen, oder anders ausgedrückt der Gradient des Feldes entlang der räumlichen Anordnung der Magnetfeldsensoren ist im Wesentlichen Null. Das heißt, mittels der Magnetfeldsensoren der integrierten Magnetfeldmessvorrichtung lassen sich die sogenannten magnetischen Gleichfelder auf einfache Weise ausblenden. Untersuchungen haben nämlich gezeigt, dass derartige Gleichfelder in allen drei Magnetfeldsensoren ein im Wesentlichen gleiches Offsetsignal erzeugen, d. h. die Offsetsignale lassen sich mittels einer Subtraktion weitestgehend eliminieren. Hierdurch wird die Sensitivität der Magnetfeldmessvorrichtung weiter erhöht.

In einer ersten Weiterbildung wird vor der Ermittlung des Abstands mittels eines Vergleich des Quotienten mit einer Wertetabelle eine Linearisierung durchgeführt wird, so dass sich zwischen dem ermittelten Abstand und dem Quotienten eine proportionale Abhängigkeit ergibt. In einer alternativen Ausführungsform wird ein Abstand zwischen dem ersten Magnetfeldsensor und dem zweiten Magnetfeldsensor und zwischen dem zweiten Magnetfeldsensor und dem dritten Magnetfeldsensor derart verändert, dass sich eine proportionale Abhängigkeit zwischen dem Quotienten und dem ersten Abstand ergibt.

Gemäß einer Weiterbildung sind der erste Magnetfeldsensor, der zweite Magnetfeldsensor und der dritte Magnetfeldsensor im Wesentlichen oder genau auf einer geraden Linie und / oder in der gleichen Ebene angeordnet. Ein Vorteil ist, dass sich bei der Berechnung der Differenzsignale ausschließlich der Abstand zwischen den drei Magnetfeldsensoren entlang der Gerade zu berücksichtigen ist.

Gemäß einer anderen Ausführungsform sind der erste Magnetfeldsensor, der zweite Magnetfeldsensor und der dritte Magnetfeldsensor hinsichtlich des Betriebsstroms In Serie verschaltet. Hierdurch lassen Unterschiede In der Signalerzeugung der einzelnen Magnetfeldsensoren durch eine unterschiedliche Bestromung ausschließen. Alternativ weist jeder Magnetfeldsensor eine Strom- oder Spannungsquelle auf.

In einer bevorzugten Ausführungsform sind der erste Magnetfeldsensor, der zweite Magnetfeldsensor und der dritte Magnetfeldsensor jeweils als 3-D Magnetfeldsensoren ausgebildet. Unter einem 3-D Magnetfeldsensor wird vorliegend ein Magnetfeldsensor verstanden, der das Magnetfeld in drei Raumrichtungen misst. Vorzugsweise ist ein derartiger Magnetfeldsensor aus drei im Wesentlichen zueinander orthogonal ausgebildeten Magnetfeldsensorteilen ausgebildet. Ein Vorteil ist, dass die Sensitivität der Magnetfeldmessvorrichtung unabhängig von der räumlichen Lage der Magnetfeldmessvorrichtung in Bezug zu der räumlichen Lage des stromdurchflossenen Leiters bzw. des zu messenden Magnetfeldes ist.

Gemäß einer Weiterbildung sind der erste Magnetfeldsensor, der zweite Magnetfeldsensor und der dritte Magnetfeldsensor jeweils als Hallsensoren ausgebildet. Derartige Hallsensoren lassen sich innerhalb eines Halbleiterfertigungsprozess und Insbesondere innerhalb eines CMOS-Prozesses kostengünstig und zuverlässig herstellen.

In einer anderen Ausführungsform ist eine Steuereinrichtung für die Ermittlung und Auswertung der Sensorsignale vorgesehen, wobei die Steuereinrichtung ausgebildet und eingerichtet ist, eine erste Differenz aus dem ersten Sensorsignal und dem zweiten Sensorsignal und eine zweite Differenz aus dem dritten und dem zweiten Sensorsignal zu bestimmen. Des Weiteren ist die Steuereinrichtung ausgebildet und eingerichtet einen Quotienten aus der ersten Differenz von zwei Sensorsignalen und der zweiten Differenz von zwei Sensorsignalen zu bilden und aus einem Vergleich des Quotienten mit einem vorgegebenen Wert den Abstand der Magnetfeldmessvorrichtung zu dem stromdurchflossenen Leiter zu ermitteln.

In einer anderen Weiterbildung ist in dem Halbleiterkörper eine integrierte Schaltung vorgesehen, wobei die integrierte Schaltung eine Stromquelle und eine Auswerteschaltung und / oder eine Steuereinrichtung umfasst, wobei die integrierte Schaltung eine elektrische Wirkverbindung mit den Magnetfeldsensoren aufweist, d.h. die Magnetfeldsensoren und die Steuereinrichtung sind monolithisch in dem Halbleiterkörper integriert Es versteht sich, dass die integrierte Schaltung mittels unterhalb von einer Passivierungsschicht ausgebildeten Leiterbahnen mit Metallflächen, den sogenannten Pads, verschaltet ist. Die Metallflächen sind mittels Bonddrähte mit Anschlusskontakten, den sogenannten Pins, verbunden. Bevorzugt ist, dass der Halbleiterkörper mit dem Metallträger verbunden und in einem Gehäuse vorzugsweise aus Kunststoff eingebettet ist, d.h. die Magnetfeldmessvorrichtung ist monolithisch integriert.

Untersuchungen haben gezeigt, dass sich die integrierte Magnetfeldmessvorrichtung für ein Erkennen von Abstandsänderungen zwischen einem stromdurchflossenen Leiter und den Magnetfeldsensoren verwenden lässt. Es versteht sich, dass anstelle eines stromdurchflossenen Leiters auch der Abstand zu einem beliebigen Körper bestimmen lässt, sofern der Körper mit einem magnetischen Feld umgeben ist, welches einen räumlichen Gradienten aufweist.

Bevorzugt lässt sich die integrierte Magnetfeldmessvorrichtung für eine Kompensation des Abstands zwischen dem stromdurchflossenen Leiter oder einem magnetfeldbehafteten Körper und den Magnetfeldsensoren verwenden, indem mittels einer Abstandregelung der Abstand zwischen magnetfeldbehafteten Körper und der Magnetfeldmessvorrichtung konstant gehalten wird. Eine derartige elektronische Regelschaltung lässt sich ohne Weiteres In den Halbleiterkörper, insbesondere als weiterer Schaltungsteil der integrierten Schaltung, integrieren.

Bevorzugt lässt sich die integrierte Magnetfeldmessvorrichtung für eine Kompensation der Abweichung des Abstands zwischen dem stromdurchflossenen Leiter und den Magnetfeldsensoren von einem Sollwert verwenden. Hierdurch lässt sich aus der Messung der Magnetfeldstärke und dem Abstand zwischen Leiter und den Magnetfeldsensoren der den Leiter durchfließende Strom exakt bestimmt.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1: einen Querschnitt einer ersten Ausführungsform,
- Figur 2: eine Schaltungsanordnung der erfindungsgemäßen Ausführungsform,
- Figur 3a, 3b: eine vergrößerte Ausschnittsdarstellung auf alternative geometrische Anordnungen der drei Magnetfeldsensoren,
- Figur 4: eine perspektivische Ansicht auf einen Halbleiterkörper mit einer integrierten Schaltung,
- Figur 5a, 5b: eine schematisierte Darstellung eines Differenzenquotienten in Abhängigkeit von dem Abstand zu einem Leiter und der Verlauf der Signalintensität eines Magnetfeldsensors In Abhängigkeit des Abstands zu dem Leiter,
- Figur 6: eine schematisierte Darstellung der Richtung und Größe einer Hallspannung und einer Intensität in Abhängigkeit von Hallelementen für eine stromdurchflossene Leiterschleife.

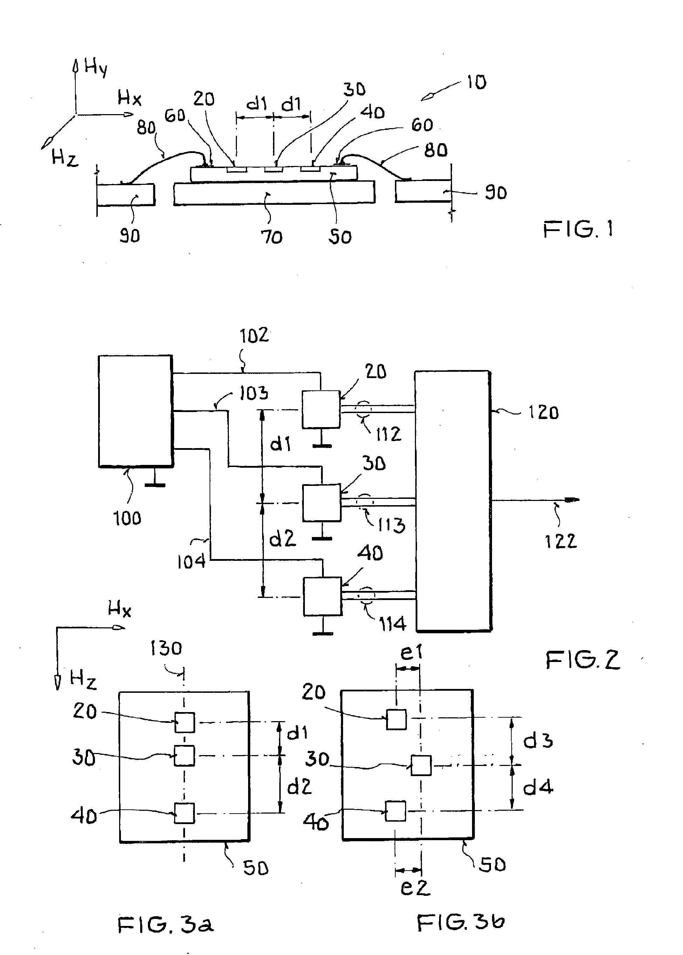

Die Abbildung der Figur 1 zeigt eine Ausführungsform einer integrierten Magnetfeldmessvorrichtung 10 mit einem ersten Magnetfeldsensor 20, einem zweiten Magnetfeldsensor 30 und einem dritten Magnetfeldsensor 40. Die Magnetfeldsensoren 20, 30 und 40 sind vorliegend aus Vereinfachungsgründen als 1-dimenslionale Sensoren, vorzugsweise als 1- dimensionale Hallsensoren, ausgeführt und in einem Halbleiterkörper 50 ausgebildet. Der Halbleiterkörper 50 weist eine erste Oberfläche auf. An der ersten Oberfläche des Halbleiterkörpers 50 sind mehrere Metallflächen 60, sogenannte Pads, angeordnet. Der Halbleiterkörper 50 Ist auf einem Metallträger 70 angeordnet und vorzugsweise mit dem Metallträger stoffschlüssig verbunden. Des Weiteren sind die Metallflächen 60 mittels von Bonddrähten 80 mit Anschlusskontakten 90 verschaltet Die Anschlusskontakte werden auch als Pins bezeichnet. Zur Veranschaulichung ist ein Koordinatensystem mit einer ersten Magnetfeldkomponente Hx, mit einer zweiten Magnetfeldkomponente Hy und einer dritten Magnetfeldkomponente Hz eingezeichnet. Aus Gründen der Übersichtlichkeit ist ein um die vorstehend angeführten Komponenten ausgebildetes Gehäuse nicht dargestellt.

Zwischen dem ersten Magnetfeldsensor 20 und dem zweiten Magnetfeldsensor 30 ist ein erster Abstand d1 ausgebildet. Zwischen dem zweiten Magnetfeldsensor 30 und dem dritten Magnetfeldsensor 40 ist ebenfalls der erste Abstand d1 ausgebildet, d.h. der zweite Magnetfeldsensor 30 ist gleich weit von dem ersten Magnetfeldsensor 20 wie von dem dritten Magnetfeldsensor 40 entfernt. Ferner sind die Magnetfeldsensoren 20, 30 und 40 in Bezug auf die Richtung eines äußeren Magnetfeldes, insbesondere hinsichtlich des Erdmagnetfeldes, identisch ausgerichtet. Demgemäß sind die Magnetfeldsensoren 20, 30 und 40 parallel zu einer Ebene, aufgespannt von den beiden Magnetfeldrichtungen Hx und Hz, ausgebildet, sodass ein Magnetfeld entlang der Hy Richtung, bei einer Ausführung der Magnetfeldsensoren als eindimensionale Hallsensoren zu einer Hallspannung UHall führt.

In einer alternativen, nicht dargestellten Ausführungsform sind die Magnetfeldsensoren 20, 30 und 40 als 3-dimensionale Magnetfeldsensoren bzw. als 3-dimensionale Hallsensoren ausgeführt, so dass jeder der Magnetfeldsensoren bzw. der Hallsensoren sowohl die Magnetfeldkomponente Hx, als auch die Magnetfeldkomponente Hy als auch die die Magnetfeldkomponente Hz erfasst.

Weist ein zwischen den einzelnen Magnetfeldsensoren 20, 30 und 40 anliegendes Magnetfeld einen Gradienten entlang der Erfassungsrichtung der Magnetfeldsensoren 20, 30 und 40 auf, wie beispielsweise das Magnetfeld eines stromdurchflossenen ersten Leiter - nicht dargestellt - so weist ein erstes Sensorsignal des ersten Magnetfeldsensors 20 im Vergleich zu einem zweiten Sensorsignal des zweiten Magnetfeldsensors 30 eine unterschiedliche Signalhöhe auf.

Des Weiteren weist auch das zweite Sensorsignal des zweiten Magnetfeldsensors 30 im Vergleich zu einem dritten Sensorsignal des dritten Magnetfeldsensors 40 eine unterschiedliche Signalhöhe auf. In Verbindung mit dem vorgegebenen ersten Abstand d1 zwischen den Magnetfeldsensoren 20, 30 und 40 läst sich durch Bildungen von Differenzenquotienten der unterschiedlichen Sensorsignalhöhen der Abstand der Magnetfeldsensoren 20, 30 und 40 und hierdurch der Abstand der integrierten Magnetfeldmessvorrichtung 10 zu dem stromdurchflossenen ersten Leiter ermitteln. Genauer ausgeführt wird aus einer Subtraktion von dem ersten Sensorsignal und dem zweiten Sensorsignal eine erste Differenz bestimmt und aus einer Subtraktion von dem dritten und dem zweiten Sensorsignal eine zweite Differenz bestimmt. Hiernach bestimmt sich der Abstand zu dem stromdurchflossenen Leiter aus dem Differenzenquotienten aus der ersten Differenz und der zweiten Differenz. Des Weiteren wird mittels der Subtraktion oder bei der Ermittlung der Gradienten ein überlagertes magnetisches Gleichfeld, beispielsweise wie das Erdmagnetfeld, nahezu vollständig eliminiert.

In der Figur 2 ist ein Teil einer stark vereinfachten Schaltungsanordnung der integrierten Magnetfeldmessvorrichtung 10 dargestellt. Im Folgenden werden nur die Unterschiede zu der Ausführungsform der Figur 1 erläutert. Von einer Stromquelle 100, als Teil einer nicht näher dargestellten integrierten Schaltung, wird mittels einer ersten Leitung 102 den ersten Magnetfeldsensor 20, mittels einer zweiten Leitung 103 den zweiten Magnetfeldsensor 30 und mittels einer dritten Leitung 104 den dritten Magnetfeldsensor 40 mit einem Betriebstrom oder einer Versorgungsspannung beaufschlagt. Der erste Magnetfeldsensor 20 ist mittels einer ersten Verbindung 112, der zweite Magnetfeldsensor 30 ist mittels einer zweiten Verbindung 113 und der dritte Magnetfeldsensor 40 ist mittels einer dritten Verbindung 114 mit einer Auswerteschaltung 120 elektrisch verschaltet. Es sei angemerkt, dass die erste Verbindung 112, die zweite Verbindung 113 und die dritte Verbindung 114 vorliegend jeweils als sogenannte "Zwei-Drahtverbindung" ausgeführt sind und dass bei der Ausführung der Magnetfeldsensoren 20, 30 und 40 als Hallsensoren von der Auswerteschaltung 120 die jeweilige Hallspannung der Hallsensoren mittels der jeweiligen Zwei-Drahtverbindung ausgewertet wird. Alternativ lassen sich auch andere Eindraht - oder Mehrdrahtverbindungen verwenden. Von der Auswerteschaltung 120 wird an einem Ausgang 122 ein analoges oder digitales Signal zur Verfügung gestellt. Vorzugsweise ist das Signal am Ausgang 122 proportional zu der ermittelten Distanz zwischen der Magnetfeldmessvorrichtung 120 und dem ersten Leiter. Im Unterschied zu der Ausführungsform in der Figur 1 ist ein zweiter Abstand d2 zwischen dem zweiten Magnetfeldsensor 30 und dem dritten Magnetfeldsensor 40 ausgebildet. Der zweite Abstand d2 ist unterschiedlich zu dem ersten Abstand d1 ausgeführt.

In den Figuren 3a und 3b ist eine vergrößerte Ausschnittsdarstellung als Draufsicht auf unterschiedliche alternative geometrische Anordnungen der drei Magnetfeldsensoren 20, 30 und 40 dargestellt, Im Folgenden werden nur die Unterschiede zu den Ausführungsformen der vorangegangen Figuren erläutert. In der Abbildung der Figur 3a liegen alle drei Magnetfeldsensoren 20, 30 und 40 in einer von den Magnetfeldrichtungen Hx ,Hz aufgespannten Ebene und entlang einer ersten Geraden 130, wobei der erste Abstand d1 kleiner als der zweite Abstand d2 ausgeführt ist. Zwar liegen in der Figur 3b gleichfalls alle Magnetfeldsensoren in einer Ebene, jedoch ist der erste Magnetfeldsensor 20 gegenüber dem zweiten Magnetfeldsensor 30 seitlich um eine erste Strecke e1 und der dritte Magnetfeldsensor 40 gegenüber dem zweiten Magnetfeldsensor 30 seitlich um eine zweite Strecke e2 versetzt. Gemäß einer nicht dargestellten alternativen Ausführungsform sind die beiden Strecken e1 und e2 gleich groß. Ferner ist zwischen dem ersten Magnetfeldsensor 20 und dem zweiten Magnetfeldsensor 30 entlang der Richtung Hz eine dritter Abstand d3 und zwischen dem zweiten Magnetfeldsensor 30 und dem dritten Magnetfeldsensor 40 ein vierter Abstand d4 ausgebildet. Gemäß einer nicht dargestellten alternativen Ausführungsform ist der dritte Abstand d3 mit dem vierten Abstand d4 identisch.

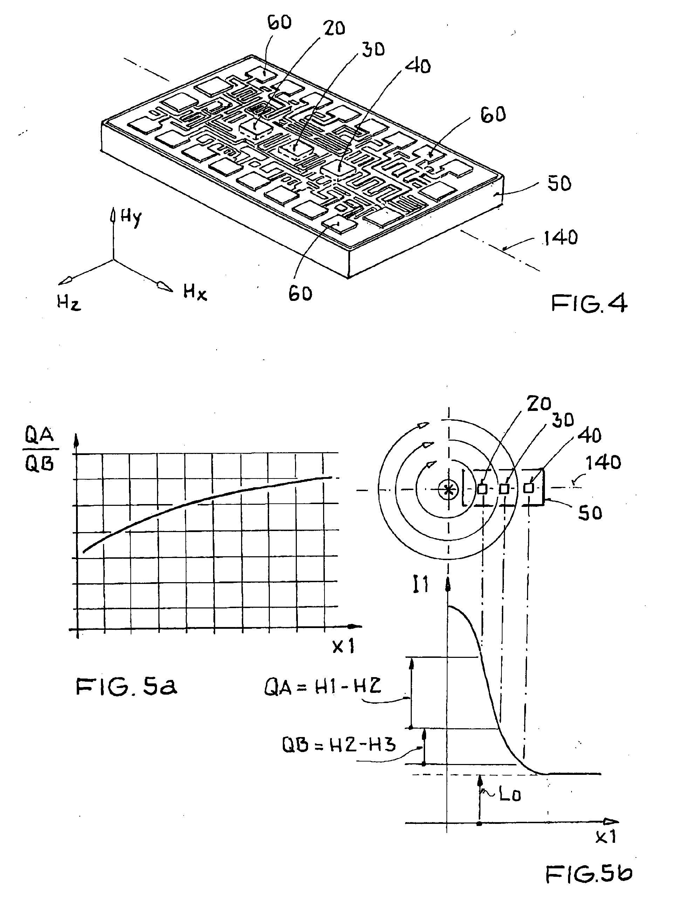

In der Figur 4 ist eine perspektivische Ansicht auf einen Halbleiterkörper mit einer Integrierten Schaltung dargestellt. Im Folgenden, werden nur die Unterschiede zu den Ausführungsformen der vorangegangen Figuren erläutert. Die drei Magnetfeldsensoren 20, 30 und 40 sind entlang einer zweiten Geraden 140 angeordnet und von einer integrierten Schaltung umgeben. Die integrierte Schaltung umfasst unter anderem die Auswertschaltung 120 und die Stromquelle 110. Aus Gründen der Übersichtlichkeit sind der Metallträger 90 und die elektrischen Anschlüsse von dem Metallflächen 60 mittels Bonddrähte 80 sowie das ausgebildete Gehäuse nicht abgebildet.

In den Figur 5a ist eine schematisierte Darstellung eines Differenzenquotienten Q in Abhängigkeit von einem Abstand X1 zu einem magnetfeldbehafteten, d.h. stromdurchflossenen Leiter und in der Figur 5b der Verlauf der Signalintensität I1 der Magnetfeldsensoren 20, 30 und 40 in Abhängigkeit von dem Abstand X1 zu dem magnetfeldbehafteten Leiter dargestellt. Im Folgenden werden nur die Unterschiede zu den Ausführungsformen der vorangegangen Figuren erläutert. Es zeigt sich in der Abbildung der Figur 5a, dass sich mittels den drei Magnetfeldsensoren 20, 30 und 40 und einen definierten und bekannten Abstand Dx der Magnetfeldsensoren 20, 30 und 40 zueinander, der Abstand X1 der Magnetfeldmessvorrichtung 10 zu dem magnetfeldbehafteten Leiter einfach ermitteln lässt. Es sei angemerkt, dass durch eine Korrekturtabelle oder durch einen veränderten Abstand Dx zwischen den Magnetfeldsensoren 20, 30 und 40 sich eine proportionale Abhängigkeit zwischen dem Differenzenquotienten QA / QB und dem Abstand X1 einstellen lässt.

In dem oberen Teil der Figur 5b sind die auf einer Geraden angeordneten Magnetfeldsensoren 20, 30 und 40 im Magnetfeld des stromdurchflossenen Leiters dargestellt. Hierzu korrespondierend ist in dem unteren Teil der Figur 5b der funktionale Verlauf einer Signalintensität I1 in Abhängigkeit des Abstandes X1 dargestellt. Es zeigt sich, dass jeder der drei Magnetfeldsensoren 20, 30 und 40 jeweils einen konstanten Fremdfeldanteil L0 eines räumlich konstanten Magnetfelds an der gemessenen Signalintensität I1 aufweist. Des Weiteren ergibt sich eine erste Differenz QA aus der Subtraktion der Signalintensität H1 des ersten Magnetfeldsensors 20 von der Signalintensität H2 des zweiten Magnetfeldsensors 30 und eine zweite Differenz QB aus der Subtraktion der Signalintensität H2 des zweiten Magnetfeldsensors 30 von der Signalintensität H3 des dritten Magnetfeldsensors 40. Des Weiteren zeigt sich, dass sich bereits mit der Subtraktion der Fremdfeldanteil L0 eliminiert.

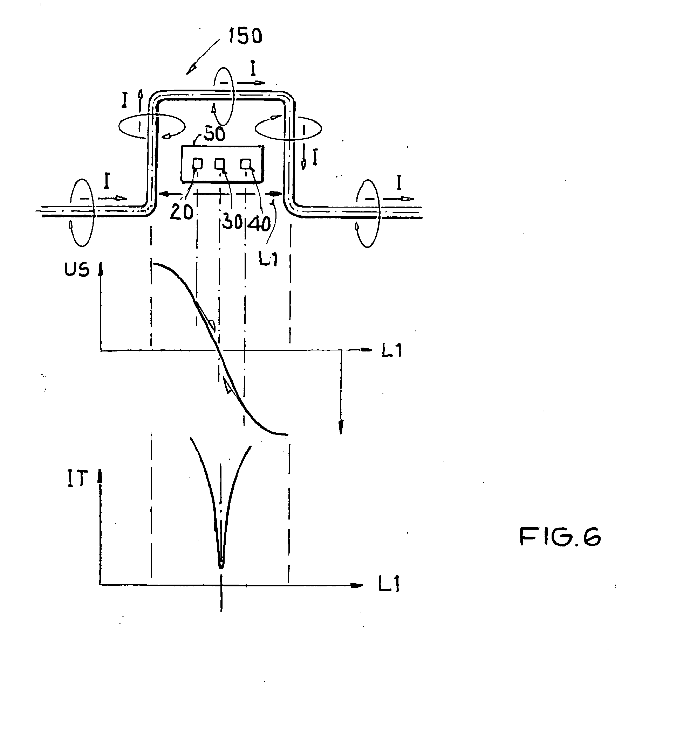

Die Figur 6 zeigt eine weitere Anwendung der erfindungsgemäßen Messfeldvorrichtung 10. Im Folgenden werden nur die Unterschiede zu den Ausführungsformen der vorangegangen Figuren erläutert. In dem oberen Teil der Figur 6 ist eine Leiterschleife 150, in der ein Strom I fließt ausgebildet. Zwischen den beiden Enden, d.h. in der lichten Schleifenweite L1 der Leiterschleife 150, ist die Magnetfeldmessvorrichtung 10, stark vereinfacht in Form von auf einer Geraden angeordneten Magnetfeldsensoren 20, 30 und 40, angeordnet.

Hierzu korrespondierend ist in dem mittleren Teil der Figur 6 der funktionale Verlauf der Richtung und der Größe einer Hallspannung US für die als Hallelemente ausgebildeten Magnetfeldsensoren 20, 30 und 40 in Abhängigkeit einer lichten Schleifenweite L1 der Leiterschleife 150 abgebildet.

Korrespondierend zu dem mittleren Teil der Figur 6 ist in dem unteren Teil der Figur 6 der funktionale Zusammenhang einer Hallsignalintensität IT in Abhängigkeit der lichten Schleifenweite L1 der Leiterschleife 150 abgebildet. Es zeigt sich, dass bei einer mittigen Anordnung der drei Magnetfeldsensoren 20, 30 und 40, der erste Magnetfeldsensor 20 und der dritte Magnetfeldsensor 40 in etwa die gleiche Signalstärke erzeugen, während dem gegenüber der zweite Magnetfeldsensor 30 in etwa genau kein Signal erzeugt. Ein Vorteil ist, dass sich anhand des Signalverlaufs, insbesondere des zweiten Magnetfeldsensors 30 eine genaue Positionierung der Messfeldvorrichtung 10 erzielen lässt.

## Patentansprüche

1. Verfahren zur Bestimmung eines Abstandes (X1) eines stromdurchflossenen ersten Leiters mittels einer integrierten Magnetfeldmessvorrichtung (10), wobei die integrierte Magnetfeldmessvorrichtung aufweist, einen Halbleiterkörper (50) mit einem in dem Halbleiterkörper (50) ausgebildeten ersten Magnetfeldsensor (20) und zweiten Magnetfeldsensor (30) und dritten Magnetfeldsensor (40), wobei von dem ersten Magnetfeldsensor (20) ein erstes Sensorsignal bereitgestellt wird und von dem zweiten Magnetfeldsensor (30) ein zweites Sensorsignal bereitgestellt wird und von dem dritten Magnetfeldsensor (40) ein drittes Sensorsignal bereitgestellt wird, und
der erste Magnetfeldsensor (20) und der zweite Magnetfeldsensor (30) und der dritte Magnetfeldsensor (40) von dem Magnetfeld des ersten Leiters gleichzeitig durchdrungen werden,
**dadurch gekennzeichnet, dass**
zur Ermittlung des Abstandes (X1) der Magnetfeldmessvorrichtung von dem stromdurchflossenen Leiter eine erste Differenz aus dem ersten Sensorsignal und dem zweiten Sensorsignal und eine zweite Differenz aus dem dritten und dem zweiten Sensorsignal bestimmt wird und anschließend ein Quotient aus der ersten Differenz und der zweiten Differenz gebildet wird.

2. Verfahren nach Anspruch 1, **dadurch gekennzeichnet, dass** vor der Ermittlung des Abstands (X1) mittels eines Vergleich des Quotienten mit einer Wertetabelle eine Linearisierung durchgeführt wird, so dass sich zwischen dem ermittelten Abstand und dem Quotienten eine proportionale Abhängigkeit ergibt.

3. Verfahren nach Anspruch 1, **dadurch gekennzeichnet, dass** ein Abstand (Dx) zwischen dem ersten Magnetfeldsensor (20) und dem zweiten Magnetfeldsensor (30) und zwischen dem zweiten Magnetfeldsensor (30) und dem dritten Magnetfeldsensor (40) derart verändert wird, dass sich eine proportionale Abhängigkeit zwischen dem Quotienten und dem ersten Abstand ergibt.

4. Integrierte Magnetfeldmessvorrichtung (10) zur Bestimmung eines ersten Abstandes (X1) der Magnetfeldmessvorrichtung zu einem stromdurchflossenen ersten Leiter mit
- einem auf einem Metallträger (70) angeordneten Halbleiterkörper (50),
- einem in dem Halbleiterkörper (50) ausgebildeten ersten Magnetfeldsensor (20) mit einem ersten Sensorsignal und einem in dem Halbleiterkörper (50) ausgebildeten zweiten Magnetfeldsensor (30) mit einem zweiten Sensorsignal und einem in dem Halbleiterkörper (50) ausgebildeten dritten Magnetfeldsensor (30) mit einem dritten Sensorsignal, und der erste Magnetfeldsensor (20), der zweite Magnetfeldsensor (30) und der dritte Magnetfeldsensor (40) einen unterschiedlichen Abstand zu dem ersten Leiter aufweisen und das Magnetfeld des ersten Leiters gleichzeitig den ersten Magnetfeldsensor (20), den zweiten Magnetfeldsensor (30) und den dritten Magnetfeldsensor (40) durchdringt,
**dadurch gekennzeichnet, dass**
eine Steuereinrichtung ausgebildet und eingerichtet ist, eine erste Differenz aus dem ersten Sensorsignal und dem zweiten Sensorsignal und eine zweite Differenz aus dem dritten Sensorsignal und dem zweiten Sensorsignal zu bestimmen und einen Quotienten aus der ersten Differenz und der zweiten Differenz zu bilden und aus dem Quotienten den ersten Abstand (X1) zwischen der Magnetfeldmessvorrichtung und dem ersten Leiter zu ermitteln (10).

5. Integrierte Magnetfeldmessvorrichtung (10) nach Anspruch 4, **dadurch gekennzeichnet, dass** der erste Magnetfeldsensor (20), der zweite Magnetfeldsensor (30) und der dritte Magnetfeldsensor (40) im Wesentlichen auf einer geraden Linie angeordnet sind.

6. Integrierte Magnetfeldmessvorrichtung (10) nach Anspruch 4 oder Anspruch 5, **dadurch gekennzeichnet, dass** die Magnetfeldsensoren (20, 30, 40) und die Steuereinrichtung monolithisch in dem Halbleiterkörper (50) integriert sind.

7. Integrierte Magnetfeldmessvorrichtung (10) nach einem vorstehenden Anspruch 1, **dadurch gekennzeichnet, dass** der erste Magnetfeldsensor (20), der zweite Magnetfeldsensor (30) und der dritte Magnetfeldsensor (40) jeweils als 3 D Magnetfeldsensor ausgebildet sind.

8. Integrierte Magnetfeldmessvorrichtung (10) nach einem vorstehenden Anspruch, **dadurch gekennzeichnet, dass** der erste Magnetfeldsensor (20), der zweite Magnetfeldsensor (30) und der dritte Magnetfeldsensor (40) jeweils als Hallsensoren ausgebildet sind.

9. Integrierte Magnetfeldmessvorrichtung (10) nach einem vorstehenden Anspruch, **dadurch gekennzeichnet, dass** der zweite Magnetfeldsensor (30) von dem ersten Magnetfeldsensor (20) und dem dritten Magnetfeldsensor (40) unterschiedlich beabstandet ist.

10. Verwendung des Verfahrens oder der integrierten Magnetfeldmessvorrichtung (10) nach einem der vorstehenden Ansprüche für ein Erkennen von Abstandsänderungen zwischen dem Leiter und den Magnetfeldsensoren (20, 30, 40).

11. Verwendung des Verfahrens oder der integrierten Magnetfeldmessvorrichtung (10) nach einem der vorstehenden Ansprüche für eine Kompensation der Abweichung des Abstands zwischen dem Leiter und den Magnetfeldsensoren (20, 30, 40) von einem Sollwert.

12. Verwendung des Verfahrens oder der integrierten Magnetfeldmessvorrichtung (10) nach einem der vorstehenden Ansprüche zur Ausblendung eines Magnetfeldes, wobei die Änderung des magnetischen Flusses zwischen dem ersten Magnetfeldsensor (20) und dem zweiten Magnetfeldsensor (30) und dem dritten Magnetfeldsensor (40) genau Null oder nahezu Null ist.

13. Verwendung des Verfahrens oder der integrierten Magnetfeldmessvorrichtung (10) nach einem der vorstehenden Ansprüche zur Bestimmung des Stromes in einem beabstandeten Leiter.
